(19) Europäisches Patentamt
European Patent Office
Office européen des brevets

(11) **EP 1 641 591 B1**

(12) **EUROPÄISCHE PATENTSCHRIFT**

(45) Veröffentlichungstag und Bekanntmachung des Hinweises auf die Patenterteilung:
**07.01.2009** Patentblatt **2009/02**

(21) Anmeldenummer: **04738906.9**

(22) Anmeldetag: **02.07.2004**

(51) Int Cl.:
*B23K 26/073* (2006.01)    *B23K 26/14* (2006.01)
*B23K 26/40* (2006.01)     *B26F 3/16* (2006.01)
*C03B 33/09* (2006.01)     *C03B 33/10* (2006.01)
*B28D 1/22* (2006.01)      *H01L 21/78* (2006.01)

(86) Internationale Anmeldenummer:
**PCT/DE2004/001490**

(87) Internationale Veröffentlichungsnummer:
**WO 2005/002779 (13.01.2005 Gazette 2005/02)**

(54) **VERFAHREN ZUM TRENNEN FLACHER WERKSTÜCKE AUS KERAMIK MIT EINER BERECHNETEN STRAHLFLECKLÄNGE**

METHOD FOR SEPARATING FLAT CERAMIC WORKPIECES WITH A CALCULATED RADIATION SPOT LENGTH

PROCEDE POUR SEPARER DES PIECES PLANES EN CERAMIQUE AVEC UNE LONGUEUR DE TACHE D'IRRADIATION CALCULEE

(84) Benannte Vertragsstaaten:
**AT BE BG CH CY CZ DE DK EE ES FI FR GB GR HU IE IT LI LU MC NL PL PT RO SE SI SK TR**

(30) Priorität: **02.07.2003   DE 10330179**

(43) Veröffentlichungstag der Anmeldung:
**05.04.2006** Patentblatt **2006/14**

(73) Patentinhaber: **JENOPTIK Automatisierungstechnik GmbH**
**07745 Jena (DE)**

(72) Erfinder:
• **WEISSER, Jürgen**
  **07743 Jena (DE)**
• **ACKER, Stefan**
  **07646 Waldeck (DE)**
• **ULLMANN, Ronny**
  **07768 Altenberga (DE)**

(74) Vertreter: **Schaller, Renate et al Patentanwälte Oehmke & Kollegen Neugasse 13 07743 Jena (DE)**

(56) Entgegenhaltungen:
WO-A-93/20015          WO-A-20/04060823
US-A1- 2003 024 909    US-B1- 6 327 875
US-B1- 6 420 678

• DATABASE WPI Section Ch, Week 198008 Derwent Publications Ltd., London, GB; Class L01, AN 1980-14182C XP002305390 & SU 666 143 A (CONS MAT IND AUTOM) 5. Juni 1979 (1979-06-05)
• PATENT ABSTRACTS OF JAPAN Bd. 013, Nr. 431 (C-640), 26. September 1989 (1989-09-26) & JP 1 167248 A (CENTRAL GLASS CO LTD), 30. Juni 1989 (1989-06-30)
• DATABASE WPI Section Ch, Week 198750 Derwent Publications Ltd., London, GB; Class L01, AN 1987-354329 XP002305391 & SU 1 308 573 A (CONS GLASS RES INST) 7. Mai 1987 (1987-05-07)
• PATENT ABSTRACTS OF JAPAN Bd. 199, Nr. 810, 31. August 1998 (1998-08-31) & JP 10 116801 A (ROHM CO LTD), 6. Mai 1998 (1998-05-06)

EP 1 641 591 B1

## Beschreibung

Die Erfindung betrifft ein Verfahren zum Trennen flache Werkstücke aus Keramik gemäß dem oberbegriff des Anspuchs 1 (such, zum Beispiel, US-BI-6327 875)

Beim Trennen auf der Basis thermisch induzierter Spannungen wird durch zeitlich und örtlichen Wärmeeintrag und/oder -entzug im Material ein Temperaturgradient erzeugt, der Spannungen bewirkt, die zu einer Rissbildung führen. Die Trennung kann durch die Ausbildung eines das Material vollständig durchdringenden Risses erfolgen oder aber durch die Ausbildung eines Tiefenrisses und anschließende Trennung durch eine mechanische Krafteinwirkung.

Aus dem Stand der Technik sind eine Vielzahl derartiger Verfahren bekannt, die durch die verschiedensten Maßnahmen das Verfahrensergebnis, das insbesondere in einer hohen Qualität der Trennkante besteht, optimieren soll. Zwar sollen die in der Patentliteratur beschriebenen Verfahren in der Regel auf spröde, nichtmetallische Materialien insgesamt anwendbar sein und damit auch auf Keramik, jedoch sind die beschriebenen Ausführungsbeispiele auf Glas beschränkt, was mit Blick auf die nachfolgenden Erläuterungen verständlich wird.

Vermutlich wird das Trennen von Glas durch thermisch induzierte Spannungen das erste Mal in dem 1964 angemeldeten Patent DE 1244246 erwähnt. Ein Laserstrahl wird mit einem geringen Strahlquerschnitt und damit einer hohen Energiedichte über die Oberfläche eines mit einer strahlungsabsorbierenden Schicht versehenen Flachglases geführt (Laserlinie), infolge dessen es durch Wärmeleitung zu einer Erwärmung des Glases von der Oberfläche her entlang der Laserlinie kommt. Es wurde erkannt, dass es hierbei nicht auf den absoluten Wert der Erhitzung des Glases ankommt, sondern auf den Temperaturgradienten im Glas quer zur Laserlinie, der insbesondere durch eine der Erwärmung folgende Kühlung erzielbar ist. Es wurde bereits damals festgestellt, dass es zur Ausbildung des erforderlichen Temperaturgradienten nicht erforderlich ist, das Glas bis auf seine Schmelztemperatur zu erhitzen und dass die Qualität der Trennfläche infolge eines Thermorisses gegenüber der durch Aufschmelzen des Glases eine andere ist.

Spätere Veröffentlichungen beschäftigen sich mit der Optimierung dieses Grundlagenverfahrens zur Erhöhung der Trenngeschwindigkeit, Verbesserung der Genauigkeit der Linienführung der Trennlinie (Trenngenauigkeit) und der Oberfläche der Trennkante (Kantenqualität).

Wie 1992 in der WO 93/20015 aufgezeigt, ist die Trenngenauigkeit bei derartigen Verfahren bis dahin aus folgenden Gründen nicht ausreichend:

Die Rissausbildung beginnt an der Kante einer Glasscheibe zu einem Zeitpunkt, an dem sich der Strahlfleck bereits von der Kante entlang der Laserlinie entfernt hat. Innerhalb dieses Bereiches, zwischen der Kante der Glasscheibe und dem Strahlfleck, entsteht eine komplexe Verteilung von Wärmespannungen, die vorerst nur Druckspannungen bewirken, die jedoch noch nicht zur Ausbildung von Rissen führen. Mit dem Auftreffen des Kühlmittels, was zu einem schlagartigen Wärmeentzug führt, entstehen Zugspannungen, die nunmehr bei Überschreitung der Zugfestigkeit des Glases zur Rissbildung führen. Während des Vorrückens des Risses werden die Kanten des Materials auf beiden Seiten des Risses auseinander gedrückt, wodurch mechanische Spannungen entstehen, welche die weitere Ausbreitung des Risses fördern. Bei Annäherung des Risses an die Begrenzung der Platte krümmt sich der Riss relativ zur Laserlinie, was in dieser Schrift durch die Asymmetrie der Wärmespannungen in der Glasplatte erklärt wird.

Eine verbesserte Trenngenauigkeit und Trenngeschwindigkeit verspricht die Auswahl bestimmter Verfahrensparameter entsprechend einer in der WO 93/20015 aufgezeigten Gleichung, nach der ein Tiefenriss spezifischer Richtung und Tiefe entstehen soll. Nach dieser Gleichung wird die Relativgeschwindigkeit gewählt, abhängig von der Länge und Breite eines elliptischen Strahlquerschnittes, wie er aus SU-A-1231813 bekannt ist, einem Proportionalitätsfaktor, der von den thermophysikalischen und mechanischen Eigenschaften des Glases sowie der Strahlleistungsdichte bestimmt ist, dem Abstand Strahlfleck und Kühlzone sowie der gewünschten Risstiefe, die von der Materialdicke des Werkstückes bestimmt wird.

Obwohl so nicht explizit erwähnt, dient die Parameterauswahl unter Verwendung dieser Formel letztendlich einem möglichst definierten örtlich verteiltem Einbringen von Wärmespannungen.

Spätere Patente entwickeln insbesondere die Geometrie des Strahlflecks weiter, die den Energieeintrag optimieren soll. Dabei werden die Ausführungsbeispiele jeweils an Hand von Glas erläutert.

So wird in der WO 96/20062 anstelle einer bislang üblichen Gaußverteilung der Energiedichte im Strahlfleck eine Energiedichteverteilung vorgeschlagen, die von der Peripherie zum Zentrum hin abnimmt (elliptischer Ring). Die EP 0 872 303 schlägt eine Strahlfleckform mit einer Energiedichteverteilung entsprechend einer U- oder V-Kurve vor.

Die US 6 327 875 B1 offenbart ein Verfahren zum Trennen flacher Werkstücke aus Glas oder anderem spröden Material durch Provokation eines Trennrisses in Folge von Spannungen, die durch einen zeitlichen und örtlichen Wärmeeintrag mittels Laser entlang einer gewünschten Trennlinie und einem diesem nachlaufenden zeitlich und örtlichen Wärmentzug mittels eines Kühlmittelstrahls entstehen.

Die Laserstrahlung bildet dabei auf dem Werkstück einen Strahlfleck, der in Richtung des Trennrisses eine langgestreckte Ellipse darstellt.

Das Bestreben des Standes der Technik entlang der Laserlinie homogene Wärmespannungen zu erzeugen und über spezifische Energiedichteverteilungen die Qualität des Trennrisses zu beeinflussen ist ein Indiz dafür, dass man davon ausgeht, dass amorphes Material ohne Eigenspannungen, wie dies auf viele Glassorten zutrifft, bearbeitet werden soll.

Bei der Prozessdurchführung an kristallinem Material, wie Keramik, muss man davon ausgehen, dass die den Prozessablauf bestimmenden Prozessspannungen nicht ausschließlich durch die zeitliche und örtliche Ausbildung der induzierten Wärmespannungen bestimmt werden, sondern auch die Eigenspannungen zu den Prozessspannungen beitragen. Insbesondere wenn sich größere Eigenspannungen über den Weg der gewünschten Trennlinie ändern, können die bekannten Verfahren nicht die versprochene Trennqualität erreichen. Die beschriebenen Verfahren geben auch keinen Lösungsansatz für das eingangs beschriebene Problem des Krümmens der Trennlinie zur Laserlinie hin am Werkstückende, was von der Anmelderin als ein Problem der Eigenspannungen verstanden wird.

Neben dem außer Acht lassen der Eigenspannungen bei den bekannten Verfahren, die in der Regel angeblich für alle nichtmetallisch spröden Werkstoffe anwendbar sind, ist die Notwenigkeit des Initialrisses ein weiterer Hinweis, dass diese Verfahren praktisch nicht für Keramik geeignet sind.

Beispielsweise wird für das in der WO 96/20062 beschriebene Verfahren vorgeschlagen, einen Anschnitt (Initialriss) an der Oberfläche des Materials entlang der gewünschten Trennlinie aufzutragen, bevor der bestrahlte Abschnitt gekühlt wird. Zwar sei der Anschnitt in der Technik nicht neu und würde häufig bei thermischen Schneidverfahrenen von Platten praktiziert, jedoch ergäbe sich im Zusammenhang mit dem aufgezeigten Verfahren ein neuer Effekt, nämlich eine sehr präzise Schnittführung und hochwertige Qualität der Kanten. Auch in der EP 0448168, der WO02/48059 und der DE 19955824 wird der Initialriss als wesentliches Merkmal genannt.

Die Anmelderin selbst weiß aus praktischer Erfahrung, dass das Vorhandensein eines Initialrisses zum Trennen von Glas durch thermisch induzierte Spannungen zwingend notwendig ist. Dass ein solcher Initialriss als notwendige Voraussetzung in den Verfahrensbeschreibungen nicht in jedem Fall erwähnt wird und auch nicht in jedem Fall gesetzt wird, ist darauf zurückzuführen, dass man praktisch beginnt, von einer mechanisch geschnittenen Kante aus zu trennen, die grundsätzlich eine Vielzahl von Mikrorissen aufweist. Einer dieser Mikrorisse dient dann als Initialriss, der sich als Trennriss fortpflanzt. Setzt man jedoch dann einen zweiten Trennschnitt an dieser mit Laser geschnittenen Trennkante an, kommt es bei Beibehaltung der Prozessparameter anstelle der gewünschten gerichteten Rissbildung nur zur Erwärmung und anschließender Abkühlung, ohne dass sich ein Riss bildet, was darauf zurückzuführen ist, dass diese Kante keine Mikrorisse aufweist, die als Initialriss dienen können. Ganz deutlich wird die Notwendigkeit des Initialrisses in der DE 100 41 519 gezeigt, die ein Verfahren zum Trennen einer Flachglasscheibe in mehrere Rechteckplatten offenbart. Hier wird deutlich, dass es dem Fachmann bekannt ist, dass er zum Trennen von Glasplatten, ausgehend von einer Trennkante entstanden durch thermisch induzierte Spannungen, zwingend einen Initialriss benötigt.

Neben dem Bestreben, über die Prozessdauer stets einen homogenen Wärmeeintrag entlang der Laserlinie zu erreichen und dem zwingenden Setzen eines Initialrisses, sofern die Kante, an der der Schnitt angesetzt wird, keine Mikrorisse aufweist, hat die Anmelderin einen weiteren Mangel erkannt, weshalb die bekannten Verfahren nicht ohne weiteres auf das Trennen von Keramik im Allgemeinen anwendbar sind.

Grundsätzlich wird unter Beachtung der Schmelztemperatur und des zu trennenden Materials sowie gegebener Strahlfleckgeometrie und Energiedichteverteilung im Strahlfleck ein Wärmeeintrag über eine optimierte Parameterkombination der Laserleistung, der Länge des Strahlflecks und der Vorschubgeschwindigkeit bewirkt, die zu Spannungen führen, die ausreichend hoch sind, damit sich der Initialriss fortpflanzt.

Es gibt keinen Hinweis im aufgezeigten Stand der Technik, dass der Spielraum für die Wahl der Länge des Strahlfleckes durch die Eigenschaften des zu trennenden Materials nach oben hin begrenzt ist oder unter deren Beachtung optimal ausgewählt wird.

Tatsächlich kann Glas sowohl mit kleinen aber auch großen Strahlflecklängen (ca. 2-50 mm) in Abhängigkeit von der Geschwindigkeit getrennt werden und die Strahlflecklänge muss nicht angepasst werden, wenn unterschiedliche Gläser geschnitten werden sollen.

Bei Keramik hingegen, so haben Versuche der Anmelderin gezeigt, ist der Bereich, den die Strahlflecklänge haben kann, damit in der Keramik der gewünschte Riss erzeugt wird, nicht nur wesentlich kleiner, sondern für die verschiedenen Keramiken auch unterschiedlich.

Wie bereits erwähnt, gibt es im aufgezeigten Stand der Technik kein Ausführungsbeispiel, bei dem ausdrücklich Keramik getrennt werden soll.

In der Praxis wird Keramik durch mechanisches Sägen getrennt bzw. mittels Laser durch sogenanntes "Scriben", was fälschlicherweise auch als Ritzen bezeichnet wird. Es handelt sich hierbei um kein wirkliches Ritzen, sondern um einen Materialabtrag in Form von Sacklöchern entlang einer Linie. Eine Laserbearbeitungsanlage zur Durchführung eines Verfahrens dieser Art ist aus dem Prospektmaterial der Firma ProCom Systemhaus und Ingenieurunternehmen GmbH unter dem Namen CNC300 bekannt.

Durch das Schmelzen und Verdampfen des Materials werden sehr hohe Spannungen eingebracht, die zur Mikrorissbildung im Gefüge führen können.

Auf stark verspannte Keramik kann das Verfahren nicht angewendet werden. Es entsteht ein undefinierter Wildbruch. Entscheidender Nachteil ist auch die Verschmutzung der Werkstückoberfläche durch Ablagerungen der Verdampfungsrückstände.

Der Erfindung liegt die Aufgabe zugrunde, ein Verfahren auf Basis des Trennens von Material mittels thermisch induzierten Spannungen, die zu einer Rissausbildung entlang einer Trennlinie führen, zu finden, mit dem in flache Werkstücke aus Keramik mit einer hohen Prozessgeschwindigkeit ein Tiefenriss definierter Tiefe eingebracht werden kann, damit die Biegefestigkeit der Keramik entlang dieser Trennlinie definiert verringert wird, um anschließend mit definierter Krafteinwirkung das Werkstück entlang der Trennlinie trennen zu können

Die Aufgabe der Erfindung wird für ein Verfahren zum Trennen eines flachen Werkstückes aus Keramik mit den Merkmalen des Anspruches 1 gelöst.

Vorteilhafte Ausführungsformen sind in den Unteransprüchen beschrieben.

Über die ursprüngliche Annahme der Anmelderin, spannungsbehaftete Keramik nur dann aufgabengemäß trennen zu können, wenn die Prozessparameter über den Prozess in Beachtung der Eigenspannung des Werkstückes verändert werden, hat die Anmelderin danach gesucht, wie sie für die sinnvoll veränderbaren Parameter, Laserleistung und Vorschubgeschwindigkeit ein hinreichend großes Prozessfenster erhält. Sie ist hierbei zu der Erkenntnis gelangt, dass sie als wesentlichen Parameter die Strahlflecklänge in Abhängigkeit von der Wärmeleitfähigkeit (WLF) des Werkstückes und dessen Dicke festlegen muss und hat hierfür eine geeignete Formel gefunden. Bei entsprechend gewählter Strahlflecklänge ergeben sich für die Einstellung der Laserleistung und der Vorschubgeschwindigkeit (Prozessgeschwindigkeit) ein hinreichend großes Prozessfenster, so dass diese Parameter innerhalb des Prozessfensters gezielt verändert werden können bzw. Schwankungen z.B. der Laserleistung oder der auftreffenden Strahlungsdichte durch Unebenheiten in der Werkstückoberfläche toleriert werden können. Es hat sich auch gezeigt, dass bei entsprechender Strahlflecklänge eine gezielte Änderung der Prozessparameter nicht zwingend erforderlich ist, wenn die Eigenspannungen im Werkstück nur gering im Verhältnis zu den Spannungen sind, die erzeugt werden müssen, damit sich im Werkstück ein Riss ausbildet.

Bei der Herstellung keramischer Werkstücke treten in den verschiedenen Produktionsstufen, bei der Nachbehandlung oder der Montage grundsätzlich mechanische Spannungen auf. Insbesondere bei ungleichmäßiger Erwärmung oder Abkühlung (z.B. Abkühlung nach dem keramischen Brand, thermische Nachbehandlungen zur Oberflächenbehandlung oder zum Aufbringen von Schichten) und durch das Schwinden werden Spannungen im Werkstück "eingefroren" bzw. führen diese zu bleibenden Formveränderungen. Diese Spannungen lassen sich insbesondere erklären durch den unterschiedlichen Wärmeausdehnungskoeffizienten der keramischen Körnung (Scherben) und der Schmelzphase (Verunreinigungen) und der damit verbundenen unterschiedlichen Ausdehnung des Gefügeaufbaus sowie unterschiedlicher Wärmeausdehnungskoeffizienten zwischen der Keramik (keramische Körnung und Verunreinigungen) und einem Beschichtungsmaterial. Darüber hinaus können zusätzliche Eigenspannungen in das Material eingebracht worden sein durch starke mechanische Kräfte bei der Formgebung oder eine mechanische Bearbeitung des Werkstückes, wie das mechanische Schneiden der Kanten.

Die Eigenspannungen kann man im Allgemeinen nicht berechnen, jedoch begrenzt experimentell bestimmen.

Es ist ein erster Gedanke der Erfindung, dass insbesondere bei Werkstücken mit hoher bzw. sich stark über die gewünschte Trennlinie ändernde Eigenspannung vor Beginn des Trennprozesses die Eigenspannungen des Werkstückes entlang der gewünschten Trennlinie erfasst werden. Primär erfolgt diese Erfassung messtechnisch. Sekundär kann nach einer Vielzahl von Vermessungen und Zuordnung der Messergebnisse zu einer jeweiligen Oberflächenkrümmung des Werkstückes entlang der gewünschten Trennlinie auch durch visuellen Vergleich der Krümmungen der Werkstücke rückwirkend auf die Eigenspannungen geschlossen werden.

Die Eigenspannungsmessung sollte vorteilhafterweise an zwei Proben einer Werkstückcharge durchgeführt werden, wobei die Erfassung an der zweiten Probe dazu dient, die Ergebnisse der ersten Probe zu bestätigen. Sind die Ergebnisse innerhalb der vorgegebenen Toleranzgrenzen gleich, kann man davon ausgehen, dass auch die anderen Werkstücke dieser Charge einen vergleichbaren Spannungsverlauf entlang der Trennlinie aufweisen. Unter Werkstücke einer Charge sollen solche Werkstücke verstanden werden, die unter identischen Herstellungsbedingungen und gegebenenfalls Bearbeitungsbedingungen hergestellt und bearbeitet wurden und die die gleichen Abmessungen, insbesondere die gleiche Materialdicke aufweisen.

Die Eigenspannungen können auch durch Versuche experimentell ermittelt werden.

Um in der Keramik einen Tiefenriss konstanter Tiefe über das gesamte Werkstück zu erzielen, ist es wichtig gemäß du Erfindung, dass die induzierten Spannungen in Summe mit den Eigenspannungen den Bereich der kritischen Bruchspannungen (Spannungen bei denen eine Rissbildung erfolgt) erreicht. Nun könnten zwar die Eigenspannungen der zu trennenden Keramikplatte entlang der gewünschten Trennlinie ermittelt werden und die zulässigen Bruchspannungen sind in der Regel vom Hersteller der Keramikplatte zu erfahren, jedoch können die sich daraus ergebenden zu induzierenden Spannungen nicht trivial als Funktion des Weges über die Laserlinie eingestellt werden.

Die induzierten Wärmespannungen sind eine Funktion von einer Vielzahl von Prozess-und Materialparametern, nämlich:

- Leistung der Laserstrahlung
- Leistungsdichteverteilung im Strahlfleck
- Form und Fläche des Strahlflecks
- Relativgeschwindigkeit zwischen Strahlfleck und Werkstück
- Materialeigenschaften des Werkstückes,

- Wärmephysikalische Eigenschaften des Kühlmittels
- Form und Fläche des Kühlquerschnitts sowie Abstand zum Strahlquerschnitt

Es bleibt daher nur die Möglichkeit, über eine Vielzahl von Versuchen Parameterkombinationen zu ermitteln, die eine Wärmespannung bewirken, die in Summe mit den Eigenspannungen den gewünschten Tiefenriss erzeugt.

Bei gegebenen Materialeigenschaften des Werkstückes, den ebenfalls innerhalb eines Trennprozesses nicht veränderbaren Eigenschaften des Kühlmittels sowie der nur schwerlich während des Prozesses veränderbaren Strahl- und Kühlmittelquerschnitte bleiben für eine experimentelle Variation insbesondere die Leistung der Laserstrahlung und die Vorschubgeschwindigkeit. Um hierfür einen hinreichend großen Spielraum (Prozessfenster) zu haben, ohne dass es auf Grund zu hoher Energieeinträge infolge zu hoher Strahlungsleistungen bzw. zu geringer Geschwindigkeit zu Materialerhitzungen kommt, die zum Schmelzen der Verunreinigungen führen, müssen die für den Prozess festen Parameter entsprechend ausgewählt werden.

Maximal große Prozessfenster werden erreicht, wenn der Strahlquerschnitt eine möglichst große Ausdehnung (Strahlflecklänge) in Richtung der Strahlführung (Vorschub) aufweist, d.h. je größer die Strahlflecklänge ist, desto größer ist der Spielraum, in dem die Vorschubgeschwindigkeit und Leistung der Laserstrahlung variiert werden können.

Da die Wärmeleitung im Material in alle Richtungen gleichermaßen erfolgt, wird ein höherer Wärmeeintrag in die Tiefe durch eine größere Strahlflecklänge unterstützt.

Während bei Glas die Strahlflecklänge im Rahmen der technischen Möglichkeiten nahezu beliebig lang wählbar ist, ist die Länge bei Keramik begrenzt.. Ursache hierfür ist die Wärmeleitfähigkeit (WLF) der Materialien. Während die WLF von Glas nur geringfügig schwankt, z.B. Floatglas 0,8 W/mK bis zu Borosilikatglas 1,2W/mK, kann die WLF von Keramik sowohl das 10- bis 20-fache als auch mehr als das 100-fache von Glas erreichen, z.B. ALN 180W/mK. Dieser Umstand muss bei der Geometrie der Aufheizzone (Strahlfleck), insbesondere bei deren Länge in Richtung der Vorschubgeschwindigkeit beachtet werden.

Hier setzt der zweite Gedanke der Erfindung an. Die maximal sinnvolle Strahlflecklänge wird durch die Wärmeleitfähigkeit des zu trennenden Materials bestimmt. Je höher die Wärmeleitfähigkeit ist, desto kürzer muss die Strahlflecklänge sein, damit möglichst wenig Wärme von der Trennlinie in die angrenzenden Bereiche seitlich abgeleitet wird. Gleichzeitig soll die Strahlflecklänge aber möglichst groß sein, um, wie dargelegt, ein großes Prozessfenster zu haben, in dem die Vorschubgeschwindigkeit und die Laserleistung variiert werden kann. In den Ausführungsbeispielen sind für Materialien verschiedener Wärmeleitfähigkeit Strahlflecklängen angegeben, wie sie für das jeweilige Material optimal sind, also so groß wie möglich, um ein großes Prozessfenster zu erhalten und aber auch so klein wie nötig, um die seitliche Wärmeableitung gering zu halten. Die Anmelderin hat an Hand einer Vielzahl von Versuchen eine Formel entwickelt, an Hand der eine optimale Strahlflecklänge in Abhängigkeit von der Wärmeleitfähigkeit (WFL) und der Materialdicke ermittelt wird. Eine Einstellung dieser Strahlflecklänge führt zu einem großen Prozessfenster, indem die Laserleistung und die Vorschubgeschwindigkeit hinreichend variiert werden können, um die induzierten Wärmespannungen über die Trennlinie in Abhängigkeit von den Eigenspannungen zu verändern bzw. einzustellen. In Abhängigkeit von den Eigenspannungen im Werkstück können geeignete Parameterkombinationen für die Laserleistung und die Vorschubgeschwindigkeit innerhalb des Prozessfensters gefunden werden. Dabei könne diese Parameter über den Prozessablauf variiert werden, wenn die Spannungsverhältnisse stark schwankend entlang der Laserlinie sind bzw. sie können für Werkstücke, die z.B. durch eine unterschiedliche Nachbehandlung unterschiedliche Eigenspannungen aufweisen, unterschiedlich eingestellt werden.

Auch wenn eine Änderung der Verfahrensparameter nicht notwendig ist, weil die Eigenspannungen klein sind bzw. über den Verlauf der gewünschten Trennlinie nicht stark schwanken, ist die Wahl der Strahlflecklänge an Hand der erfindungsgemäßen Formel zwingend, um einen Trennriss gemäß der Aufgabenstellung zu erhalten. Größere Strahlflecklängen führen bei sonst konstanten Verfahrensparametern nicht zur gewünschten Trennqualität bzw. der Trennprozess findet gar nicht statt, da durch die Wärmeleitung der erforderliche Temperaturgradient nicht erreicht werden kann. Kürzere Strahlflecklängen führen zu einer längern Prozessdauer oder zu sichtbaren Wechselwirkungen (Verdampfung, Aufschmelzen der Materialoberfläche). Mit der erfindungsgemäß bestimmten Strahlflecklänge lassen sich somit höchstmögliche Prozessgeschwindigkeiten erzielen. Schwankungen der Laserleistungen führen auf Grund des großen Prozessfensters nicht zur Beeinträchtigung des Verfahrens. Ebenso wirken sich Schwankungen in der Energiedichte in dem auf das Werkstück auftreffenden Strahlfleck nicht aus. Solche Energiedichtschwankungen ergeben sich, wenn sich der relative Abstand des Fokus zur Werkstückoberfläche über die Laserlinie ändert, weil z.B. die Werkstückoberfläche uneben ist. Versuche haben ergeben, dass eine Abweichung der errechneten Strahlflecklänge bis zu 10 % zu keiner wesentlichen Beeinträchtigung führt.

Die grundsätzliche Beachtung der Eigenspannungen bei der Prozessdurchführung eröffnet nicht nur die Möglichkeit einer reproduzierbaren Trennung von mit Eigenspannungen behafteter Keramik, sondern auch ein gezieltes Einbringen von mechanischen Spannungen zur Unterstützung des Trennprozesses. So können z.B. nichtoxidische Keramiken, in die auf Grund der hohen Wärmeleitfähigkeit nur schwer thermische Spannungen induziert werden können, während des Trennprozesses mechanisch so vorgespannt werden, dass der Eintrag nur noch geringer Wärmespannungen bereits zur Rissbildung führt.

Durch die Beachtung der Eigenspannung ist es beim Trennen von Keramik durch einen Tiefenriss und nachfolgende mechanische Krafteinwirkung möglich, die notwendige Krafteinwirkung in einem kleinen Toleranzbereich zu halten. Die notwendige Bruchkraft soll einerseits nicht zu gering sein, um ein vorzeitiges unabsichtliches Brechen auszuschließen, aber auch nicht zu hoch sein, um die Keramik entlang der Trennlinie schonend und mit geringem Energieaufwand zu brechen.

Insbesondere dünne Werkstücke werden vorteilhaft auf der Werkstückauflage fixiert vermessen, die auch zum nachfolgenden Trennprozess als Auflage dient. Dadurch werden auch die durch eine Verspannung infolge der Fixierung auf der Auflage entstehenden Spannungen mit erfasst.

Ein dritter Gedanke der Erfindung betrifft die Einleitung des Risses.

Das gezielte Einbringen eines Initialrisses ist für das Trennen eines Werkstückes aus Keramik gemäß der Eifindung überflüssig. Wie eine Vielzahl von Erprobungen gezeigt haben, beginnt die Rissausbildung stets entlang der Korngrenzen, an denen sich auf Grund des unterschiedlichen Ausdehnungskoeffizienten der Keramikkristalle und der diese umschließenden Schmelzphase bei der Herstellung und der Wiedererwärmung Spannungsmaxima ausbilden bzw. an Stoffübergängen, die sich beim keramischen Brand durch die Kornkontakte bilden und Schwachstellen darstellen. Der Riss breitet sich dann entlang der Korngrenzen im Bereich der Laserlinie (Linie, die der Strahlfleck überstreicht) aus. Während sich der Riss im amorphen Gefüge des Glases immer von einem Initialriss ausgehend geradlinig ausbreitet, erfolgt die Rissbildung und - ausbreitung in der kristallinen Keramik mikroskopisch gesehen entlang der Korngrenzen bzw. Schwachstellen wellig. Die Strahlfleckbreite soll mindestens die Breite der größten Korndurchmesser aufweisen.

Die Erfindung soll nachfolgend am Ausführungsbeispiel an Hand von Zeichnungen näher erläutert werden.

In einem ersten Beispiel, das nicht unter dem Gegenstand der Erfindung steht, soll eine Keramikscheibe aus 96%igem Aluminiumoxid mit einer Wärmeleitfähigkeit von 24W/mK und einer Dicke von 0,63 mm mittig getrennt werden.

Mittels der erfindungsgemäßen Formel I = 8 x d x 24 / WLF, wobei I die Länge des Strahlfleckes, WLF der Betrag der Wärmeleitfähigkeit der zu trennenden Keramik und d die Dicke des zu trennenden Keramikwerkstückes ist, wird eine Strahlflecklänge von 5 mm errechnet und ein Strahlfleck mit der Strahlflecklänge von ungefähr 5mm und einer Strahlfleckbreite von ungefähr 1 mm eingestellt. Bei einer Laserleistung von 60 Watt und einer Geschwindigkeit von 100 mm/s, mit der der Strahlfleck über das Werkstück geführt wird, wird ein Tiefenriss erzeugt, der visuell nicht sichtbar ist. Bei einer anschließenden Krafteinwirkung im Bereich von 80-120 MPa wird das Werkstück entlang der Trennlinie gebrochen. Weitere in diesem Werkstück bzw. Werkstücken gleicher Materialcharge mit gleicher Parameterwahl erzeugte Tiefenrisse sind mit gleicher Krafteinwirkung trennbar. Eine Schwankung der Laserleistung um 3% sowie eine Höhendifferenz von 0,75 mm über die Diagonale des Werkstückes, die zu Schwankungen der auftreffenden Strahlungsdichte entlang der Laserlinie führen, liegen innerhalb des Prozessfensters und sind daher unproblematisch. Versuche haben gezeigt, dass bei dieser Ellipsenlänge des Strahlflecks und einer Laserleistung von 60 W die Vorschubgeschwindigkeit zwischen 50 mm/s und 150 mm/s variiert werden kann, bei ansonsten unveränderten Verfahrensparametern. Die Laserleistung kann bei einer Vorschubgeschwindigkeit von 100 mm/s zwischen 54 und 66 W variiert werden.

In einem anderen Beispiel, das nicht im Gegenstand der Erfindung steht, soll eine Keramikscheibe aus Zirkoniumoxid mit einer Wärmeleitfähigkeit von 2,4 W/mK und einer Dicke von ebenfalls 0,63 mm getrennt werden. Für die Länge des Strahlflecks werden 50 mm gewählt, die gewählte Vorschubgeschwindigkeit und Laserleistung entsprechen denen des ersten Ausführungsbeispiels. Eine Variation dieser Laserleistung und der Vorschubgeschwindigkeit entsprechend dem ersten Ausführungsbeispiel ist möglich, ohne das eine Auswirkung auf die Rissbildung festgestellt werden kann.

In einem Ausführungsbeispiel gemäß der Erfindung soll eine Keramik gemäß dem ersten Ausführungsbeispiel getrennt werden, die mit aufgebrachten Kupferstrukturen versehen sehr hohe Eigenspannungen aufweist, die bei der Prozessdurchführung nicht mehr vernachlässigt werden können. Die Eigenspannungen in dieser Keramik sind in dem nicht beschichteten Randbereich deutlich geringer als in dem Bereich der Kupferstrukturen. Bei ansonsten gleichen Parametern für den Strahlfleck und die Materialdicke wird zum Trennen der Keramik entlang einer Linie zwischen den Strukturen entweder die Laserleistung fest eingestellt und die Vorschubgeschwindigkeit über die Laserlinie variiert oder die Vorschubgeschwindigkeit fest eingestellt und die Laserleistung über die Laserlinie variiert.

So wird z.B. bei einer Laserleistung von 60 W die Vorschubgeschwindigkeit im freien Randbereich beginnend auf 100 mm/s eingestellt, dann im beschichteten Bereich auf 70 mm/s verringert und dann beim Verlassen des beschichteten Bereiches wieder auf 100 mm/s erhöht. Beide Vorschubgeschwindigkeiten liegen innerhalb des Prozessfensters, welches sich für die ermittelte Strahlflecklänge für dieses Keramikmaterial und diese Werkstückdicke ergibt (s.1. Ausführungsbeispiel).

Anstelle die Vorschubgeschwindigkeit bei konstanter Laserleistung zu variieren, kann auch die Laserleistung bei konstanter Vorschubgeschwindigkeit verändert werden. So kann beispielsweise bei einer konstanten Vorschubgeschwindigkeit von 100 mm/s, beginnend mit einer Laserleistung von 60 W, erst der freie Randbereich, dann mit 66 W der strukturierte Bereich auf einer Linie zwischen den Strukturen und abschließend wieder der freie Randbereich mit einer Laserleistung von 60 W beaufschlagt werden, um den gewünschten Trennriss zu erzeugen.

**Patentansprüche**

1. Verfahren zum Trennen flacher Werkstücke aus Keramik durch Provokation eines Trennrisses in Folge von Spannungen, die durch einen zeitlichen und örtlichen Wärmeeintrag mittels Laser entlang einer gewünschten Trennlinie und einem diesem nachlaufenden zeitlich und örtlichen Wärmeentzug mittels eines Kühlmittels entstehen, wobei die Laserstrahlung auf dem Werkstück einen Strahlfleck bildet, dessen Strahlflecklänge in Richtung der Trennlinie größer als dessen hierzu senkrechte Strahlfleckbreite ist,
**dadurch gekennzeichnet,**
**dass** die Strahlflecklänge aus folgender Formel berechnet wird:

$$l = 8 \times d \times 24 / WLF$$

wobei l die Länge des Strahlfleckes, WLF der Betrag der Wärmeleitfähigkeit der zu trennenden Keramik und d die Dicke des zu trennenden Keramikwerkstückes ist, um in Abhängigkeit von der Wärmeleitfähigkeit des Werkstükkes und dessen Materialdicke die Strahlflecklänge so einzustellen, dass sie so klein wie nötig ist, damit der erforderliche Temperaturgradient zur Erzeugung des Trennrisses trotz Wärmeleitung noch erreichbar ist, aber auch so groß wie möglich ist, um einen möglichst schnellen Wärmeeintrag und damit eine hohe Prozessgeschwindigkeit zu erreichen,
**dass** zur Einleitung des Trennprozesses kein Initialriss erzeugt wird und
**dass** vor Beginn des Trennprozesses die Eigenspannungen des Werkstückes entlang der gewünschten Trennlinie erfasst werden und die Leistung oder die Geschwindigkeit während des Trennvorgangs in Beachtung der Eigenspannungen ortsabhängig so gesteuert werden, dass die Wärmespannungen und die Eigenspannungen entlang der Trennlinie in Summe die zur Rissbildung notwendige Bruchspannung erreichen.

2. Verfahren nach Anspruch 1 **dadurch gekennzeichnet,**
**dass** das Werkstück unter Vorspannung auf einer Werkstückauflage gehalten wird, um damit zusätzlich die Prozessspannungen stützende Spannungen zu erzeugen.

3. Verfahren nach Anspruch 1, **dadurch gekennzeichnet,**
**dass** das Werkstück zur Vermessung der Eigenspannung auf der Werkstückauflage fixiert ist, auf dem das Werkstück auch während des Trennprozesses und in gleicher Weise gehalten wird.

**Claims**

1. A method for separating flat ceramic workpieces through provocation of a separation crack due to stresses occurring by temporal and local application of heat from a laser along a desired separating line and, following this, a temporal and local removal of heat by means of a coolant, wherein the laser radiation forms a beam spot whose beam spot length in the direction of the separating line is greater than the width of the beam spot perpendicular thereto,
**characterized in that**
the beam spot length is calculated from the following formula:

$$l = 8 \times d \times 24 / WLF,$$

where l is the length of the beam spot, WLF is the absolute value of the thermal conductivity of the ceramic to be separated, and d is the thickness of the ceramic workpiece to be separated, in order to adjust the beam spot length depending upon the thermal conductivity of the workpiece and its material thickness such that, while said length is as small as necessary for achieving the temperature gradient required to generate the separating crack, said length is also as large as possible to achieve the fastest possible introduction of heat and, consequently, a high process speed,
that no initial crack is generated in order to initiate the separating process and that prior to beginning the separating process, the internal stresses of the workpiece along the desired separating line are determined and that the output or speed is controlled in a spatially oriented manner during the separating process, taking the internal stresses into consideration, such that the sum of the thermal stresses and of the internal stresses along the separating line achieve the fracture stress required to form the crack.

2. Method according to claim 1, **characterized in that** the workpiece is held on a workpiece support in a pretensioned manner, so as to produce additional stresses reinforcing the process stresses.

**3.** Method according to claim 1, **characterized in that** the workpiece is fixed to the workpiece support, on which the workpiece is also held in the same manner during the separating process, for measuring the internal stress.

**Revendications**

**1.** Procédé de séparation de pièces plates en céramique par provocation d'une fissure de séparation à cause de contraintes se formant au moyen d'une amenée temporelle et locale de chaleur par un laser selon une ligne de séparation désirée et, par la suite, un soutirage temporel et local de chaleur au moyen d'un réfrigérant, le rayonnement laser formant une tache de faisceau dont la longueur en direction de la ligne de séparation est supérieure à la largeur de la tache de faisceau perpendiculaire à cette ligne, **caractérisé**

**par le fait que** la longueur de la tache de faisceau est calculée avec la formule suivante:

$$l = 8 \times d \times 24 / WLF,$$

où $l$ est la longueur de la tache de faisceau, *WLF* est la valeur absolue de la conductibilité thermique de la céramique à séparer, et *d* est l'épaisseur de la pièce céramique à séparer, afin d'ajuster la longueur de la tache de faisceau en fonction de la conductibilité thermique de la pièce et de l'épaisseur de son matériau de sorte que, ladite longueur étant aussi petite que nécessaire pour réaliser le gradient de température requis pour former la fissure de séparation, et ladite longueur étant en même temps aussi grande que possible pour réaliser l'apport de chaleur le plus vite possible et, par conséquent, une haute vitesse du procédé,

et **par le fait qu'**il n y pas de formation d'une fissure initiale pour l'initiation du procédé de séparation et qu'avant de commencer le procédé de séparation, les contraintes internes de la pièce selon la ligne de séparation désirée sont déterminées et la puissance ou la vitesse est commandée d'une manière spatialement orientée pendant le procédé de séparation, prenant en considération les contraintes internes de sorte que la somme des contraintes thermiques et des contraintes internes selon la ligne de séparation donne la contrainte de rupture nécessaire pour la formation de la fissure.

**2.** Procédé selon la revendication 1, **caractérisé en ce que** la pièce est maintenue sur un porte-pièce mis en précontrainte de manière à produire des contraintes additionnelles qui renforcent les contraintes de procédé.

**3.** Procédé selon la revendication 1, **caractérisé en ce que** la pièce est fixée au porte-pièce sur lequel la pièce est aussi maintenue de la même façon pendant le procédé de séparation, pour mesurer la contrainte interne.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6327875 B1
- DE 1244246
- WO 9320015 A
- SU 1231813 A
- WO 9620062 A
- EP 0872303 A
- EP 0448168 A
- WO 0248059 A
- DE 19955824
- DE 10041519